Europäisches Patentamt

European Patent Office

Office européen des brevets

(11) Veröffentlichungsnummer: **0 474 176 A2**

## EUROPÄISCHE PATENTANMELDUNG

(21) Anmeldenummer: **91114818.7**

(22) Anmeldetag: **03.09.91**

(51) Int. Cl.5: **H01L 23/498**, H01L 23/15

(30) Priorität: **07.09.90 DE 4028363**
**10.05.91 DE 4115316**

(43) Veröffentlichungstag der Anmeldung:
**11.03.92 Patentblatt 92/11**

(84) Benannte Vertragsstaaten:
**DE FR GB**

(71) Anmelder: **TELEFUNKEN SYSTEMTECHNIK GMBH**
**Sedanstrasse 10**
**W-7900 Ulm (Donau)(DE)**

(72) Erfinder: **Feurer, Ernst, Dr.**
**Im Riedle 10**
**W-7906 Blaustein(DE)**

Erfinder: **Jarney, Günther**
**Birkenried**
**W-8883 Gundelfingen(DE)**
Erfinder: **Holl, Bruno, Dr.**
**Rapunzelweg 31**
**W-7900 Ulm(DE)**
Erfinder: **Schmidt, Dieter**
**Ulmer Strasse 11**
**W-7917 Vöhringen(DE)**

(74) Vertreter: **Schulze, Harald Rudolf, Dipl.-Ing. et al**
**TELEFUNKEN SYSTEMTECHNIK GMBH**
**Sedanstrasse 10**
**W-7900 Ulm(DE)**

(54) **Dünnfilm-Mehrlagenschaltung und Verfahren zur Herstellung von Dünnfilm-Mehrlagenschaltungen.**

(57) Die Erfindung betrifft eine Dünnfilm-Mehrlagenschaltung, die aus mindestens einer Schichtfolge von mehreren Leiterbahnschichten mit dazwischenliegenden organischen Polymer-Isolationsschichten besteht, welche Schichtfolge auf einem Substrat aufgebracht ist, sowie ein Verfahren zur Herstellung solcher Dünnfilm-Mehrlagenschaltungen auf Polyimidbasis. Die Erfindung ist dadurch gekennzeichnet, daß als Substrat Aluminiumnitrid, Siliziumnitrid oder Metall, vorzugsweise Kupfer-Molybdän (CuMo) vorgesehen ist.

FIG.1

Die Erfindung betrifft eine Dünnfilm-Mehrlagenschaltung gemäß Oberbegriff des Patentanspruches 1 sowie ein Verfahren zur Herstellung von Dünnfilm-Mehrlagenschaltungen gemäß Oberbegriff des Patentanspruches 9.

Eine solche Dünnfilm-Mehrlagenschaltung bzw. ein solches Herstellungsverfahren für Dünnfilm-Mehrlagenschaltungen ist beispielsweise aus dem Artikel von Detlef Haberland: "Mehrlagen-Dünnfilmtechnologie für Mikroverdrahtungen", in: Siemens Components 28 (1990) Heft 1, Seite 21-23 bekannt.

Vergleichbare Schaltungen bzw. Herstellungsverfahren sind beschrieben in dem Artikel von R.O. Carlson und C.A. Neugebauer: "Aufbau und Verbindungstechniken für großintegrierte Schaltkreise mit Hochfrequenz im Vergleich" in: Verbindungstechnik in der Elektronik - Vorträge und Poster-Beiträge des 4. Internationalen Kolloquiums in Fellbach vom 23.-25. Februar 1988 (Veranstalter: Deutscher Verband für Schweißtechnik e.V. (DVS), Düsseldorf), Seite 1-4.

Die zunehmende Integrationsdichte und Verarbeitungsgeschwindigkeit leistungsstarker IG's erfordern neuartige Packaging-Technologien und nur durch den Einsatz mehrlagiger Metallstrukturen kann die hohe Anzahl von I/O-Pads auf kürzestem Weg verbunden werden. Bewährte Techniken wie z.B. Multilayer-Leiterplatten mit SMD und COB-Montage oder Dickschicht-Multilayer genügen den heutigen Anforderungen oftmals nicht mehr.

Die Dünnfilm-Mehrlagentechnik ist für diesen Fall der optimale Weg, da mit dieser Technik die erforderliche Strukturfeinheit gegeben ist.

Die Aufgabe der Erfindung besteht zum einen darin, eine Dünnfilm-Mehrlagenschaltung der eingangs genannten Art zu schaffen, die die Verbindung einer möglichst hohen Anzahl von I/O-Pads auf kürzesten weg gestattet und dennoch zuverlässig arbeitet, und zum anderen darin, ein Verfahren zur Herstellung von Dünnfilm-Mehrlagenschaltung der eingangs genannten Art anzugeben, das eine möglichst wirtschaftliche Herstellung solcher Schaltungen erlaubt.

Die erfindungsgemäße Lösung der Aufgabe ist im Hinblick auf die zu schaffende Dünnfilm-Mehrlagenschaltung durch Merkmale des Patentanspruches 1 und im Hinblick auf das zu schaffende Verfahren durch die Merkmale des Patentanspruches 9 gegeben. Die Unteransprüche enthalten vorteilhafte Aus- und Weiterbildungen der Erfindung, und zwar die Patentansprüche 2 bis 8 im Hinblick auf die erfindungsgemäße Dünnfilm-Mehrlagenschaltung und die Patentansprüche 10 bis 15 im Hinblick auf das erfindungsgemäße Verfahren.

Die erfindungsgemäße Verwendung von Aluminiumnitrid, Siliziumnitrid oder Metall (z. B. Kupfer-Molybdän) als Substrat für die Dünnfilm-Mehrlagenschaltung hat sich insbesondere bei der Herstellung von Leistungshybriden als vorteilhaft erwiesen, da ein solches Substrat eine wesentlich höhere Wärmeleitfähigkeit als z.B. $Al_2O_3$ besitzt. Darüber hinaus erweisen sich die entspechenden an Silizium besser angepaßten Wärmeausdehnungskoeffizienten dieser Materialien als sehr vorteilhaft.

Im folgenden wird die Erfindung anhand der Figuren näher erläutert. Es zeigen:

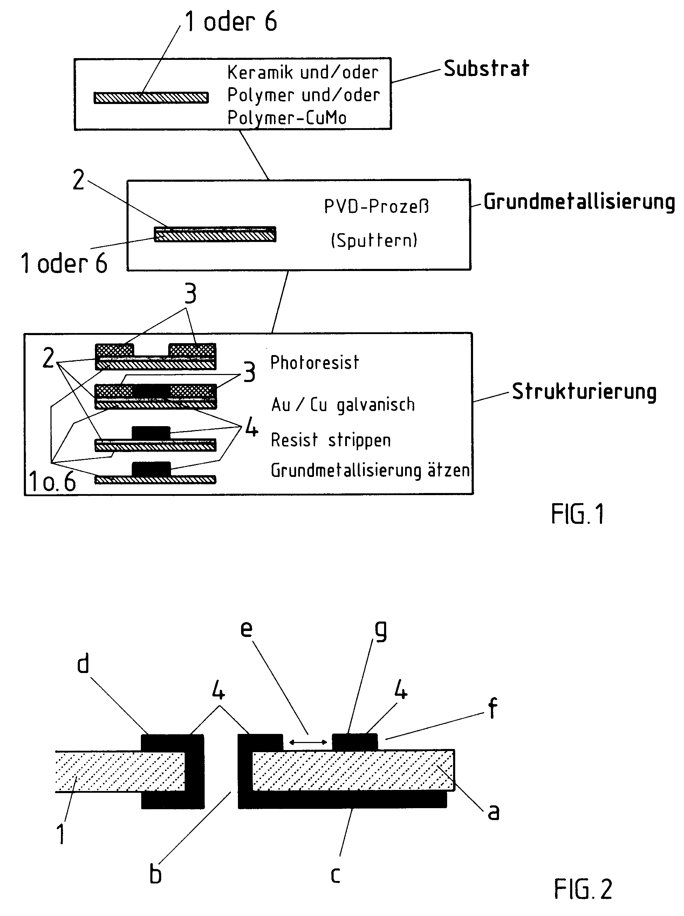

FIG. 1    die einzelnen Verfahrensschritte zur Herstellung einer Leiterbahn auf einem Keramiksubstrat und/oder einer organischen Polymer-Isolationsschicht gemäß einer vorteilhaften Weiterbildung des erfindungsgemäßen Verfahrens, die gemäß einer weiteren vorteilhaften Weiterbildung des erfindungsgemäßen Verfahrens z. B. auf einem Metallsubstrat (z. B. Kupfer-Molybdän) aufgebracht sein kann;

FIG. 2    einen Ausschnitt aus einer nach dem erfindungsgemäßen Verfahren hergestellten Dünnfilmschaltung mit einem beidseitig beschichteten Substrat und einer Durchkontaktierung;

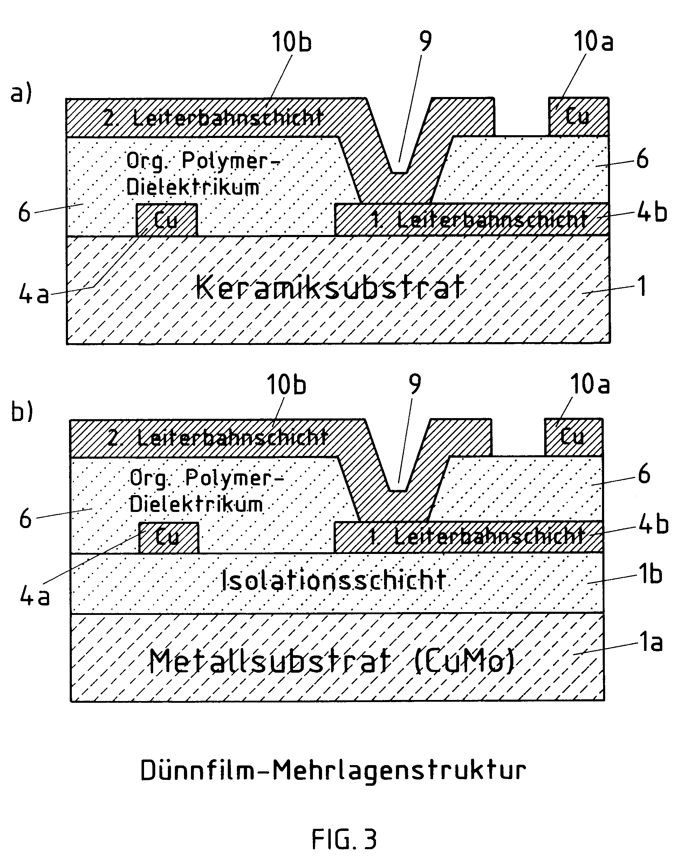

FIG. 3    einen Ausschnitt aus einer anderen nach dem erfindungsgemäßen Verfahren hergestellten Dünnfilm-Mehrlagenschaltung mit einem einseitig beschichteten Substrat und einer elektrisch leitenden Verbindung von Leiterbahnen zweier unterschiedlicher Leiterbahnschichten über ein via hole, und zwar mit einem Keramiksubstrat (FIG. 3a) bzw. mit einem Metallsubstrat (z. B. Kupfer-Molybdän), welches durch eine zusätzliche organische Polymer-Isolationsschicht von den Leiterbahnschichten isoliert ist (FIG. 3b).

Ein wesentlicher Prozeßschritt bei der Herstellung einer Dünnfilm-Mehrlagenschaltung ist gemäß FIG. 1 die Grundmetallisierung 2 des Substrats 1 und/oder der organischen Polymer-Isolationsschicht 6. Sie wird im vorliegenden Fall durch Sputtern, also z.B. durch eine physikalische oder chemische Gasphasenabscheidung (PVD = Physical Vapour Deposition bzw. CVD = Chemical Vapour Deposition), aufgebracht. Bei dieser Kathodenzerstäubung, wie der Prozeß auch genannt wird, werden in einer Glimmentladung positive Inertgasionen, meistens Argon-Ionen, erzeugt. Diese Teilchen werden zur Kathode hin beschleunigt und schlagen dort Metall-Atome aus dem Target heraus, welche sich dann auf dem Substrat 1 und/oder der Isolationsschicht 6 abscheiden.

Eigenschaften und kristalliner Aufbau der so erzeugten Metallfilme 2 hängen sehr stark von den gewählten Abscheidungsparametern ab.

Dies sind die Leistungsdichte, der Entladungsdruck, die Substrattemperatur usw.

Bei der verwendeten Dünnfilmtechnik wird zuerst die Oberfläche durch einen Sputter-Ätzprozeß konditioniert. Dabei werden mittels Argonionenbombardement die ersten Atomlagen der Substratoberfläche abgetragen. Dann wird eine dünne Chrom- oder Wolfram-Titan-Haftschicht aufgesputtert, gefolgt von einer etwa 0,5 $\mu$m dicken Kupfer- oder Gold-Leitschicht.

Nach der Grundmetallisierung 2 des Substrats 1 und/oder der Isolationsschicht 6 schließt sich gemäß FIG. 1 ein semidadditiver Schichtaufbau der Leiterbahnen an. Begonnen wird mit dem Aufbringen und Strukturieren eines Photoresists 3. Dann folgt die Verstärkung der dünnen Kupferschicht der Grundmetallisierung 2 durch eine galvanische Abscheidung von Kupfer 3 und/oder Nickel (als Diffusionssperre) und/oder Gold (was eine gute elektrische Kontaktierung z.B. durch Kleben, Bonden und/oder Löten ermöglicht) bis zur gewünschten Schichtdicke.

Ein wesentlicher Vorteil der Erfindung besteht darin, daß das Metallisierungssystem (die Grundmetallisierung) sowohl für Keramik- als auch für organische Polymerschichten verwendet werden kann, daß mit anderen Worten sowohl das Grund-Substrat als auch die Isolationsschicht(en) beispielsweise in einem Verfahrensschritt mit der Grundmetallisierung versehen werden können.

Strippen (d.h. Entfernen) des Resists 3 und Wegätzen der nicht verstärkten Grundmetallisierung 2 beenden die Strukturierung.

Weitere wesentliche Vorteile dieser verwendeten Dünnfilmtechnik sind (unter Bezugnahme auf die Buchstaben a bis g in FIG. 2):

a:      Gute mechanische, thermische und elektrische Eigenschaften des Grund-Substrates (1), wie hohe thermische Leitfähigkeit, kleiner Ausdehnungskoeffizient und ausgezeichnete HF-Eigenschaften.

b:      Niederohmige Durchkontaktierungen und beidseitige Strukturierung sind problemlos machbar.

c:      Überlegene Haftfestigkeit.
Die im Peeltest (DIN IEC 249) ermittelte Schälfestigkeit genügt allen Anwendungsmöglichkeiten. Auch auf organischen Polymerschichten wie z. B. auf verschiedenen Polyimiden (vgl. z. B. "Merck Elektronik Chemicals Photoresists"-Schrift der Firma Merck (Darmstadt)) werden ausgezeichnete Haftfestigkeiten erzielt.

d:      Optimale elektrische Leitfähigkeit.
Der spezifische Widerstand der Leiterbahnen entspricht dem des reinen Kupfers.

e:      Exakte Linienauflösung.
Eine 20 $\mu$m Strukturauflösung ist zuverlässig realisierbar.

f:      Dicke Leiterbahnen (4) sind möglich.
Mit dem Semiadditiv-Verfahren ist die Leiterbahnhöhe in einem weiten Bereich wählbar (0,5-50 $\mu$m).

g:      Universelle Bondbarkeit, Lötbarkeit.
Nach einem Nickel-Gold-Finish sind alle gängigen Kontaktierungsverfahren möglich. Der Verbund hält Löttemperaturen über 4000 c stand.

Als Isolationsschicht wird gemäß FIG. 3a) bzw. b) ein organisches Polymer 6 verwendet. Denn organische Polymere haben sich für viele Zwecke in der Mikroelektronik besser bewährt als anorganische Dielektrika wie z.B. $SiO_2$ oder $Si_3N_4$.

Ein Beispiel sind die sogenannten MCM's (Multi Chip Module), eine neuartige Packaging-Technologie, welche durch die rasante Entwicklung der VLSIC's (Very Large Scale Integrated Circuits) erforderlich wurde. Hierbei werden mehrere Chips auf engstem Raum zusammengefaßt. Durch den Einsatz von mehrlagigen Metallstrukturen können somit hohe Integrationsdichten erreicht werden.

In diesem Fall wird als organisches Polymer, z. B. das oben bereits erwähnte Polyimid, als Isolationsschicht (6 in FIG. 3a) bzw. 6 und 1b in FIG. 3b)) eingesetzt. In Verbindung mit einem gut leitenden Metall, wie z.B. Kupfer, können sehr kurze Signal-Laufzeiten erreicht werden. Bei der Herstellung dieser Strukturen werden alternierend Leiterbahnschichten (4a, 4b bzw. 10a, 10b in FIG. 3a) bzw. b)) und Isolationsschichten 6 in FIG. 3a) bzw. 6 und 1b in FIG. 3b) aufgebaut. Eine der wesentlichen Anforderungen, die dabei an den Verbund Metall-Isolator gestellt werden, ist eine gute Haftung.

Da die meisten organischen Polymere in den üblichen organischen Lösungsmitteln nahezu unlöslich sind, geht man im allgemeinen von löslichen Polymer-Vorstufen aus. Polyimidfilme beispielsweise werden durch die thermische Imidisierung einer photosensitiven Polyimid-Vorstufe, (z.B. unter Abspaltung von Wasser) hergestellt.

Die OC-N-CO-Gruppen des Polyimids sind für die in diesem Zusammenhang interessierenden wesentlichen Eigenschaften dieses polymeren Materials verantwortlich. Der sehr hohe Zersetzungspunkt ist z.B. eine charakteristische Eigenschaft, die es für die Anwendung in elektronischen Schaltungen so interessant macht. Polyimid ist bis zu einer Temperatur von T $\approx$ 400°C beständig (bei höheren Temperaturen tritt ein oxidativer Abbau ein). Aufgrund dieser hohen thermischen Stabilität eignet sich Polyimid z.B. vorzüglich als Lötstoppmaske. Die niedrige Dielektrizitätskonstante ($\epsilon r$ = 3.2) sorgt z.B. für gute Isolatoreigenschaften, und die hohe chemische Inertheit garantiert eine gute Langzeitstabilität und prädestiniert dieses Polymer z.B. für den Einsatz als Passivisierungs-, Schutz- und/oder Isolationsschicht.

Zur Herstellung der Isolationsschichten 6 gemäß FIG. 3a) bzw. 6 und 1b gemäß FIG. 3b) in den Mehrlagenschaltungen kann beispielsweise ein (an sich bekanntes) photosensitives Polyimid-Vorstufenmaterial als Ausgangsbasis eingesetzt werden (vgl. hierzu beispielsweise: "Merck Electronik Chemicals Photoresists" - Schrift der Firma Merck (Darmstadt)). Es wird in einem Schleuderprozeß als ca. 20 μm dicker Film aufgebracht. Die Polymidvorstufe besitzt vorzugsweise photoreaktive Gruppen R, die nach der Belichtung mit UV-Licht zu einem vernetzten Polymer führen. Dies bewirkt im darauffolgenden Entwicklungsprozeß eine unterschiedliche Löslichkeit der belichteten und unbelichteten Stellen, vergleichbar mit herkömmlichen Negativ-Photolacken. Im anschließenden Temperprozeß werden die vernetzten Gruppen verdampft, und die bekannte Imidisierung kann stattfinden.

Mit dieser Technologie kann heutzutage eine Strukturfeinheit bis etwa 25 μm realisiert werden.

Für eine noch feinere Strukturierung (z.B. für das Öffnen von via holes (9 in FIG. 3a) oder b)) in der organischen Polymer-Isolationsschicht (6 in FIG. 3a) oder b)) zwischen den einzelnen Leiterbahnschichten (4b, 10b in FIG. 3a) oder b)) mit Breiten von typisch 10 μm), empfiehlt sich dagegen der Einsatz von Trockenätzverfahren.

Gemäß FIG. 3a) oder b) kann nun auf der organischen Polymer-Isolationsschicht 6 die zweite Leiterbahnschicht 10a, 10b semiadditiv aufgebaut werden. Die oben besprochene Dünnfilm-Metallisierung (FIG. 1) eignet sich sowohl für Keramik (z.B. für Substrate aus Aluminiumnitrid oder Siliziumnitrid (1 in FIG. 3a))) als auch für organische Polymerschichten (z.B. die Isolationsschichten 6 in FIG. 3a) bzw. 6 und 1b in FIG. 3b)). Über via holes 9 in der als Dielektrikum wirkenden organischen Polymer-Isolationsschicht 6 werden in FIG. 3a) und b) beispielhaft die Leiterbahnschichten 10b, 4b elektrisch miteinander verbunden. Alternierend können nun auf dieselbe Art und Weise (in FIG. 3a) oder b) nicht gezeigte) weitere Leiterbahnschichten und organische Polymer-Isolationsschichten aufgebaut werden.

Für gewisse Mikrowellenkomponenten, wie z.B. Langekoppler oder planare Mikrospulen, wird als Dielektrikum Luft gefordert.
Bei der Herstellung dieser Luftbrücken wird aus einer Dünnfilm-Mehrlagenschaltung die Isolationsschicht entfernt, so daß an deren Stelle als Dielektrium Luft mit einer idealen Dielektrizitätskonstante von $\epsilon_r = 1$ tritt.

Heutzutage werden verstärkt Mehrlagenschaltungen mit sehr hoher Integrationsdichte entwickelt. Bei diesen Multi-Chip-Modulen handelt es sich um Dünnfilm-Mehrlagensubstrate bis zu einer Größe von beispielsweise 4" x 4", auf welchen eine Reihe komplexer VLSI's und andere Komponenten auf engstem Raum zusammengefaßt sind.

Als Substratmaterial wird gemäß der Erfindung Aluminiumnitrid, Siliziumnitrid oder Metall (z. B. Kupfer-Molybdän (CuMo)) verwendet (falls ein Metallsubstrat (z. B. CuMo) verwendet wird, muß - wie in FIG. 3b) gezeigt - eine weitere Isolationsschicht 1b z. B. aus organischen Polymeren zwischen dem Metallsubstrat 1a und der ersten Leiterbahnschicht 4a, 4b vorgesehen werden). Dies hat den Vorteil, daß die bei dieser extremen Integrationsdichte entstehenden beträchtlichen Verlustwärmemengen auf sehr effiziente Weise abgeführt werden können. Zudem bringt der geringere thermische Ausdehnungskoeffizient dieser Materialien bei der Montage großflächiger Silizium-Chips erhebliche Vorteile.

Es können neben einseitig strukturierten Dünnfilm-Mehrlagenschaltungen (vgl. z.B. FIG. 3a) oder b)) auch zweiseitig strukturierte Versionen realisiert werden, d.h. Dünnfilm-Mehrlagenschaltungen, bei denen die einzelnen Lagen (die einzelnen Leiterbahnschichten mit den dazwischenliegenden organischen Polymer-Isolationsschichten) auf beiden Seiten des Aluminiumnitrid- bzw. Siliziumnitrid- bzw. Metall(CuMo)-Substrats aufgebracht werden. Diese MCM's werden in Metallgehäusen hermetisch verschlossen und bilden dann ein komplettes System oder werden als sehr komplexes Subsystem auf entsprechende Mehrlagenleiterplatten montiert.

**Patentansprüche**

1. Dünnfilm-Mehrlagenschaltung, bestehend aus mindestens einer Schichtfolge von mehreren Leiterbahnschichten mit dazwischenliegenden Isolationsschichten aus organischen Polymeren, welche Schichtfolge auf ein Substrat aufgebracht ist, dadurch gekennzeichnet, daß das Substrat (1) aus Aluminiumnitrid, Siliziumnitrid oder Metall, vorzugsweise Kupfer-Molybdän (CuMo) besteht.

2. Dünnfilm-Mehrlagenschaltung nach Anspruch 1, dadurch gekennzeichnet, daß die einzelnen Leiterbahnen (4a, 4b, 10a, 10b) der Leiterbahnschichten auf ihrer Unterseite jeweils eine Grundmetallisierung (2) aufweisen in Form einer Kupfer- oder Goldleitschicht, an deren Unterseite sich eine im Vergleich zur Leitschichtdicke dünnere Chrom- oder Wolfram-Titan-Haftschicht anschließt, deren Unterseite an die Oberfläche der direkt unter der Leiterbahn liegenden Substrat- (1) und/oder organisch-polymeren Isolationsschicht (6 bzw. 1b) grenzt.

3. Dünnfilm-Mehrfachschaltung nach einem der Ansprüche 1 bis 2, dadurch gekennzeichnet, daß die einzelnen Leiterbahnen (4; 4a, 4b, 10a, 10b) der Leiterbahnschichten jeweils aus Kupfer oder Gold bestehen.

4. Dünnfilm-Mehrfachschaltung nach einem der Ansprüche 1 bis 3, dadurch gekennzeichnet, daß die einzelnen Leiterbahnen (4; 4a, 4b, 10a, 10b) der Leiterbahnschichten auf ihrer Oberseite jeweils eine im Vergleich zur Leiterbahn-Schichtdicke in etwa gleichdicke oder dünnere Nickelschicht als Diffusionssperre aufweisen.

5. Dünnfilm-Mehrfachschaltung nach einem der Ansprüche 1 bis 4, dadurch gekennzeichnet, daß die einzelnen Leiterbahnen (4; 4a, 4b, 10a, 10b) der Leiterbahnschichten auf ihrer Oberseite als äußerste Schicht jeweils eine im Vergleich zur Leiterbahn-Schichtdicke dünnere Goldschicht als Kontaktierungsschicht aufweisen.

6. Dünnfilm-Mehrlagenschaltung nach Anspruch 5, dadurch gekennzeichnet,
   - daß die Chrom- oder Wolfram-Titan-Haftschicht der Grundmetallisierung (2) einer Leiterbahnschicht eine Dicke von etwa 10 - 100 nm, vorzugsweise von etwa 30 - 50 nm, insbesondere etwa 40 nm hat;
   - daß die Kupfer- oder Goldleitschicht der Grundmetallisierung (2) einer Leiterbahnschicht eine Dicke von etwa 200 - 2000 nm, vorzugsweise 300 - 700 nm, insbesondere etwa 500 nm hat;
   - daß die einzelnen Kupfer- oder Goldleiterbahnen (4a, 4b, 10a, 10b) einer Leiterbahnschicht jeweils eine Dicke von etwa 0,5 - 50 $\mu$m, vorzugsweise 3 - 7 $\mu$m, insbesondere etwa 5 $\mu$m haben;
   - daß die Nickelschicht auf der Oberseite der einzelnen Leiterbahnen (4a, 4b, 10a, 10b) jeweils eine Dicke von etwa 0,5 - 10 $\mu$m, vorzugsweise 3 - 7 $\mu$m, insbesondere 5 $\mu$m hat;
   - daß die Gold-Kontaktierungsschicht auf der Oberseite der einzelnen Leiterbahnen (4a, 4b, 10a, 10b) jeweils eine Dicke von etwa 0,1 - 2 $\mu$m, vorzugsweise 0,5 - 1,5 $\mu$m, insbesondere 1 $\mu$m hat;
   - daß die einzelne Isolationsschicht (6) jeweils eine Dicke von etwa 5 - 40 $\mu$m, vorzugsweise 15 - 25 $\mu$m, insbesondere 20 $\mu$m haben.

7. Dünnfilm-Mehrfachschaltung nach einem der Ansprüche 1 bis 6, dadurch gekennzeichnet, daß die Verbindung von Leiterbahnen (4b, 10b) in unterschiedlichen Leiterbahnschichten über via holes (9) erfolgt.

8. Dünnfilm-Mehrfachschaltung nach einem der Ansprüche 1 bis 7, dadurch gekennzeichnet, daß sowohl auf der Oberseite des Substrats als auch auf seiner Unterseite jeweils eine Schichtfolge von einer oder mehreren Leiterbahnschichten mit dazwischenliegenden Isolationsschichten aufgebracht ist.

9. Verfahren zur Herstellung von Dünnfilm-Mehrlagenschaltungen, bei welchem Verfahren mindestens eine Schichtfolge von mehreren Leiterbahnschichten mit dazwischenliegenden Isolationsschichten aus organischen Polymeren auf ein Substrat aufgebracht wird, dadurch gekennzeichnet, daß das Substrat aus Aluminiumnitrid, Siliziumnitrid oder Metall, vorzugsweise Kupfer-Molybdän (CuMo) besteht.

10. Verfahren nach Anspruch 9, dadurch gekennzeichnet, daß die Oberfläche der direkt unter der jeweils aufzubringenden Leiterbahnschicht liegenden Substrat- und/oder organischen Polymer-Isolationsschicht zunächst mit einer Grundmetallisierung versehen wird, dergestalt, daß die Oberfläche zuerst durch einen Sputterätzprozeß konditioniert wird, daß dann allseitig eine dünne Chrom- oder Wolfram-Titan-Haftschicht aufgesputtert wird, gefolgt von einer im Vergleich zur Haftschichtdicke dickeren Kupfer- oder Goldleitschicht.

11. Verfahren nach Anspruch 10, dadurch gekennzeichnet, daß nach dem Aufbringen der jeweiligen Grundmetallisierung die Leiterbahnen der jeweils aufzubringenden Leiterbahnschicht in Form eines semiadditiven Schichtaufbaus aufgebracht werden.

12. Verfahren nach Anspruch 11, dadurch gekennzeichnet, daß der semiadditive Schichtaufbau mit dem Aufbringen und Strukturieren eines Photoresists begonnen wird, daß danach die dünne Kupfer- oder Goldleitschicht an den von dem Photoresist nicht bedeckten Stellen der Grundmetallisierung durch galvanische Abscheidung von Kupfer und/oder Nickel und/oder Gold bis zur gewünschten Schichtdicke verstärkt wird, und daß schließlich durch Strippen des aufgebrachten Photoresists mit anschließendem Wegätzen der nicht verstärkten Grundmetallisierung die Strukturisierung der jeweils aufzubringenden Leiterbahnschicht beendet wird.

13. Verfahren nach einem der Ansprüche 9 bis 12, dadurch gekennzeichnet, daß zum Aufbringen und Strukturieren der jeweils aufzubringenden organischen Polymer-Isolationsschicht zunächst das photosensitive Vorstufenmaterial mittels eines Schleuderprozesses auf die Oberfläche der unter der aufzubringenden Isolationsschicht liegenden Schicht(en) in der gewünschten Schichtdicke aufgebracht wird, daß anschließend das aufgebrachte Vorstufenmaterial leicht eingebrannt wird und dann mit durch eine mit der gewünschten Struktur versehenen Maske tretendes UV-Licht bestrahlt wird, daß danach die bestrahlte Schicht ent-wickelt wird und anschließend in einem Temperprozeß die Aushärtung des bestrahlten Vorstufenmaterials durchgeführt wird.

14. Verfahren nach einem der Ansprüche 9 bis 12, dadurch gekennzeichnet, daß zur Strukturierung der jeweils aufzubringenden organischen Polymer-Isolationsschicht ein Trokkenätzverfahren eingesetzt wird.

15. Verfahren nach einem der Ansprüche 9 bis 14, dadurch gekennzeichnet, daß zur Herstellung von Luftbrücken in Form von Leiterbahnen einer Leiterbahnschicht, die über via holes mit Leiterbahnen der darunter liegenden Leiterbahnschicht(en) verbunden sind, die dazwischenliegenden organischen Polymer-Isolationsschicht(en) entfernt wird (werden).

1 oder 6

Keramik und/oder
Polymer und/oder
Polymer-CuMo

**Substrat**

2

1 oder 6

PVD-Prozeß

(Sputtern)

**Grundmetallisierung**

3

2

3

Photoresist

Au / Cu galvanisch

4

Resist strippen

1 o. 6

Grundmetallisierung ätzen

**Strukturierung**

FIG.1

e        g

d        4        4        f

1        b        c        a

FIG.2

a)

10b       9       10a

2. Leiterbahnschicht     Cu

Org. Polymer-
Dielektrikum

6

Cu      1. Leiterbahnschicht   4b

6

Keramiksubstrat    1

4a

b)

10b       9       10a

2. Leiterbahnschicht     Cu

Org. Polymer-
Dielektrikum

6

6

Cu     1. Leiterbahnschicht   4b

4a

Isolationsschicht    1b

Metallsubstrat (CuMo)    1a

Dünnfilm-Mehrlagenstruktur

FIG. 3